Europäisches Patentamt

European Patent Office

Office européen des brevets

(11) Veröffentlichungsnummer: **0 156 251**
**B1**

(12) # EUROPÄISCHE PATENTSCHRIFT

(45) Veröffentlichungstag der Patentschrift:
07.06.89

(51) Int. Cl.⁴: **H 03 K 19/007**

(21) Anmeldenummer: 85102900.9

(22) Anmeldetag: 13.03.85

(54) Schaltungsanordnung zur Speicherung dynamischer logischer Signale.

(30) Priorität: 21.03.84 DE 3410390

(43) Veröffentlichungstag der Anmeldung:
02.10.85 Patentblatt 85/40

(45) Bekanntmachung des Hinweises auf die Patenterteilung: 07.06.89 Patentblatt 89/23

(84) Benannte Vertragsstaaten:
BE CH DE FR GB LI NL SE

(56) Entgegenhaltungen:
DE–A– 2 419 205
DE–A– 2 818 627
FR–A– 2 400 803
FR–A– 2 510 845
US–A– 3 428 825
Siemens-Zeitschrift 43(1969) Heft 8 Seiten 660-665
Die Akte enthält technische Angaben, die nach dem Eingang der Anmeldung eingereicht wurden und die nicht in dieser Patentschrift enthalten sind.

(73) Patentinhaber: Siemens Aktiengesellschaft Berlin und München
Wittelsbacherplatz 2
D-8000 München 2 (DE)

(72) Erfinder: Maier, Willi, Dipl.-Ing. (FH)
Industriestrasse 4
D-7603 Oppenau (DE)
Erfinder: Voigt, Günter, Dipl.-Ing.
Karl-Wilhelm-Strasse 16
D-7500 Karlsruhe 1 (DE)

**Beschreibung**

Die Erfindung bezieht sich auf eine Schaltungsanordnung gemäß dem Oberbegriff des Anspruchs 1.

Bei einer bekannten Schaltungsanordnung dieser Art (DE-OS 27 37 528 und Siemens-Zeitschrift 43 (1969) Heft 8, Seiten 660-665 « Drei-Phasen-MT-Schaltkreissystem für die Eisenbahnsignaltechnik ») sind Verknüpfungsschaltungen bzw. bistabile Elemente u. a. aus Magnetkernen gebildet, auf denen mehrere Eingangs- und eine Ausgangswicklung aufgebracht sind. Hiermit lassen sich UND- bzw. ODER-Verknüpfungen realisieren, die die logischen Signale (log. « 0 » als Impulsfolge und log. « 1 » als statisches Signal mit hohem oder niedrigem Potential) darstellen (sogenanntes erweitertes dynamisches Magnetkernsystem). Durch Störungen verursachte kurzzeitige Impulsausfälle beim dynamischen logischen « 0 »-Signal können hierbei zum fälschlichen Ansprechen von Verknüpfungsgliedern führen. Dieses problem ist beispielsweise bei der bekannten Schaltungsanordnung durch Behelfsschaltungen gelöst, bei denen ein statisches Signal auf einen der statischen Rücksetzeingänge eines Speicherbausteins rückgeführt wird. Hinsichtlich der Sicherheit und der fehlerselbstmeldenden Eigenschaften dieser Schaltung bei solchen Impulsstörungen sind jedoch bei vielen Anwendungsfällen Verbesserungen angebracht.

Der Erfindung liegt die Aufgabe zugrunde, eine Schaltungsanordnung zur Speicherung dynamischer logischer Signale zu schaffen, bei der Impulsausfälle während des dynamisch logischen « 0 »-Signals bis zur Dauer einiger Taktperioden toleriert werden können und die Sicherheit bei der Verarbeitung der Signale erhöht wird.

Zur Lösung dieser Aufgabe weist eine Schaltungsanordnung der eingangs genannten Art die Merkmale des Kennzeichens des Anspruchs 1 auf. Durch die erfindungsgemäße Verbindung einer Torschaltung mit einer Gleichrichterschaltung ist in vorteilhafter Weise gewährleistet, daß mit der durch die passive Gleichrichtung gewonnenen Spannung eine Stromversorgung der Torschaltung durchgeführt werden kann, wodurch kurzzeitige Impulsausfälle bei einem dynamischen logischen « 0 » nicht zu einem fehlerhaften Ansprechen der eingesetzten Speicher- bzw. Verknüpfungsglieder führen, da die Gleichspannung am Toreingang für eine vorgegebene Zeit erhalten bleibt und die Schaltungsanordnung somit nicht nach logisch « 1 » gesetzt wird.

Vorteilhafte Ausgestaltungen der erfindungsgemäßen Schaltungsanordnung sind in den Unteransprüchen angegeben.

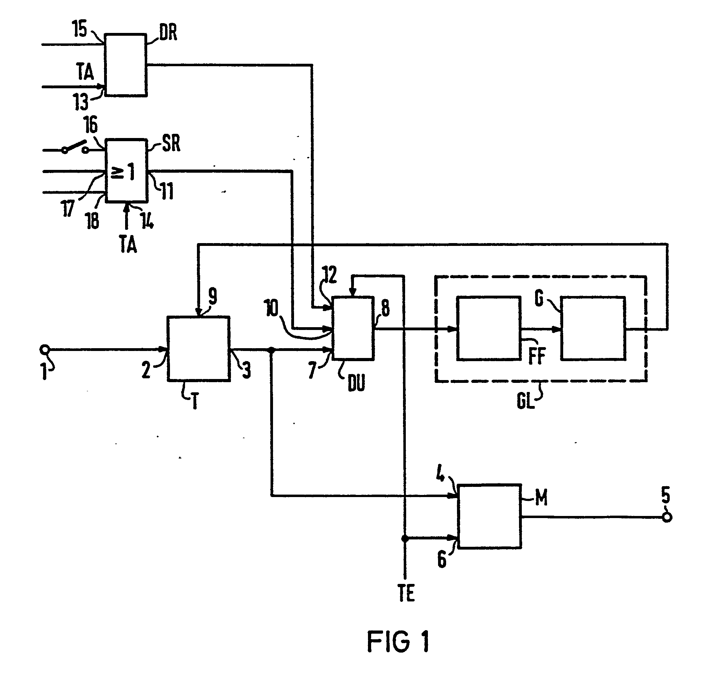

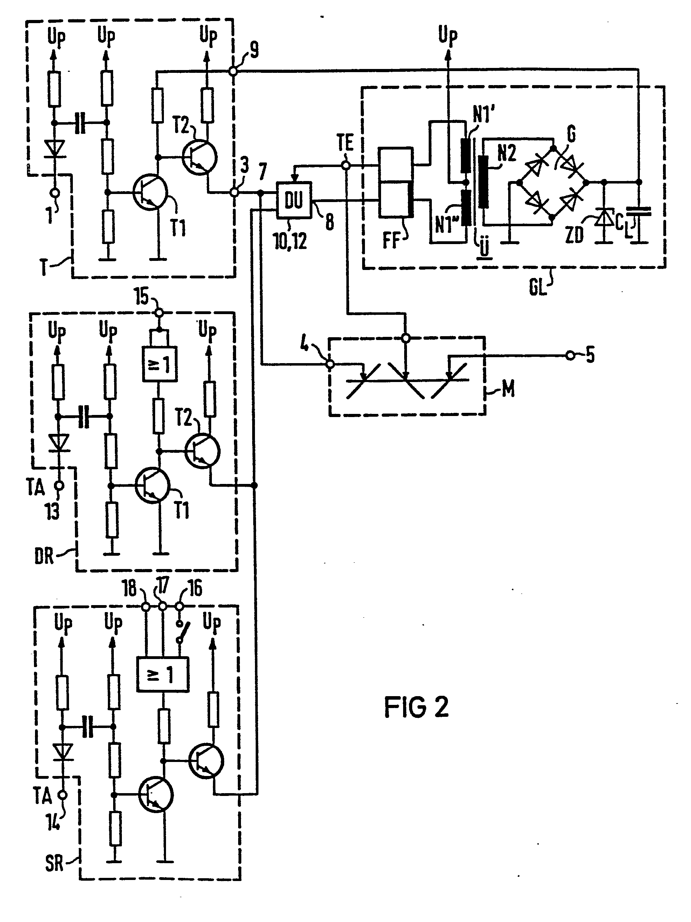

Die Erfindung wird anhand der Figuren dargestellt, wobei Figur 1 ein Blockschaltbild eines Ausführungsbeispiels der erfindungsgemäßen Schaltungsanordnung und Figur 2 ein detailliertes Schaltungsbild dieses Ausführungsbeispiels darstellt.

Bei dem in der Figur 1 dargestellten Blockschaltbild liegt an einem Eingang 1 das dynamisch logische Eingangssignal an und wird auf einen Eingang 2 einer Torschaltung T geführt. Der Ausgang 3 der Torschaltung T ist über ein Verknüpfungselement M (Eingang 4), beispielsweise einen Magnetkern-Baustein mit mehreren Eingangswicklungen und einer Ausgangswicklung, auf den Ausgang 5 der Schaltungsanordnung geführt. An einem zweiten Eingang 6 des Verknüpfungselementes M liegt ein Taktsignal TE an. Der Ausgang 3 der Torschaltung ist weiterhin an einen Eingang 7 eines dynamischen UND-Bausteins DU angeschlossen, dessen Ausgang über eine bistabile Kippstufe FF auf einen passiven (d. h. fail-safe arbeitenden) Gleichrichter G geführt ist. Der Ausgang der aus der Kippstufe FF und dem Gleichrichter G bestehenden Gleichrichterschaltung GL ist auf einen Toreingang 9 der Torschaltung T zurückgeführt.

An einen zweiten Eingang 10 des dynamischen UND-Bausteins DU ist der Ausgang 11 eines statischen Rücksetzbausteins SR geführt, und mit einem dritten Eingang 12 des dynamischen UND-Bausteins DU ist der Ausgang eines dynamischen Rücksetzbausteins DR verbunden. Weiterhin ist der dynamische UND-Baustein DU an einem zusätzlichen Eingang mit dem ersten Taktsignal TE beaufschlagt. Die Takteingänge 13 bzw. 14 der Bausteine DR und SR sind für ein Taktsignal TA ausgelegt, das zum ersten Taktsignal TE derart phasenverschoben ist, daß die Pulse in der Mitte zwischen den Impulsen des ersten Taktsignals TE liegen. An einem Eingang 15 des dynamischen Rücksetzbausteins DR ist ein statisches Freigabesignal anlegbar, das sich im dynamischen Rücksetzbaustein DR mit dem dynamischen Rücksetzsignal (Signal TA) am Eingang 13 in UND-Verknüpfung befindet. An den Eingängen 16, 17 und 18 des statischen Rücksetzbausteins SR sind statische Rücksetzsignale anlegbar, die — jedes für sich — das am Eingang 14 dauernd anstehende dynamische Signal TA auf den Ausgang 11 des statischen Rücksetzbausteins SR durchschalten.

In der Figur 2 sind die einzelnen Bausteine detaillierter dargestellt, wobei die Bausteine T, DR, SR nach herkömmlichen Schaltungsprinzipien aufgebaut sind, so daß hier nähere Erläuterungen nicht notwendig sind. Beispielsweise weist die Torschaltung T eine Schaltung mit zwei Transistoren T1 und T2 auf, die das am Eingang 1 anliegende Signal nur dann durchlassen, wenn am Toreingang 9 ein entsprechendes Gleichspannungssignal anliegt und somit der Transistor T2 angesteuert werden kann, wodurch am Ausgang 3 das dynamisch logische Signal « 0 » als Impulsfolge durchgeschaltet werden kann. Der Baustein DR ist ebenso aufgebaut, wobei hier jedoch das Durchschalten des Taktsignals TA vom Eingang 13 auf den Ausgang über ein Signal zur statischen Freigabe am Eingang 15 erfolgt. Beim statischen Rücksetzbaustein SR wird die Durchschaltung des Taktsignals TA am Eingang 14 über Signale zum statischen Rücksetzen an den Eingängen 16, 17 oder 18 bewirkt.

Die Gleichrichterschaltung GL besteht — wie schon anhand der Figur 1 ausgeführt — aus einer bistabilen Kippstufe FF, deren Ausgänge — hier bei der detaillierten Darstellung — auf Wicklungen N1' und N1" eines Übertragers Ü geführt sind. Der Verbindungspunkt der Wicklungen N1' und N1" ist mit einer Versorgungsspannung $U_P$ beaufschlagt. Die Sekundärwicklung N2 des Übertragers Ü speist einen Brückengleichrichter G, wobei am Gleichspannungszweig des Gleichrichters G eine Zenerdiode ZD mit einem nachgeschalteten Ladekondensator $C_L$ anliegt. Das am Ladekondensator $C_L$ anliegende Gleichspannungssignal ist auf den Toreingang 9 der Torschaltung T zurückgeführt.

Die Funktionsweise der Schaltungsanordnung wird nun insbesondere anhand der Darstellung nach der Figur 2 erläutert. Zunächst wird durch Aktivieren einer der beiden Rücksetzbausteine DR oder SR ein (kurzzeitiges) Durchschalten des Taktes TA auf das dynamische UND-Glied DU über den Eingang 12 bewirkt. Aufgrund des durchgeschalteten Taktsignals TA wird über die bistabile Kippschaltung FF und den Übertrager Ü eine Gleichspannung an der Zenerdiode ZD bzw. am Ladekondensator $C_L$ erzeugt. Diese Gleichspannung bewirkt über den Toreingang 9 der Torschaltung T das Durchschalten einer Impulsfolge vom Eingang 1 auf den Ausgang 3, wobei die Impulsfolge eine logische « 0 » darstellt. Nun liegt für die gesamte Dauer einer Impulsfolge am Eingang 1 ein Signal für die Gleichrichterschaltung GL und über das Verknüpfungselement M am Ausgang 5 der Schaltungsanordnung an. Wenn jedoch Lücken der Impulsfolge am Eingang 1 aufgrund einer Störung auftreten, so bewirkt die Gleichspannung am Toreingang 9 für einen vorgegebenen Zeitraum ein Geöffnethalten der Torschaltung Tr so daß nach Wiede, erscheinen der Impulse am Eingang 1 innerhalb dieses Zeitraumes diese wiederum am Ausgang 5 erscheinen können. Die Zeitdauer, in der nach Ausfall der Impulsfolge am Eingang 1 die Spannung am Toreingang 9 noch anliegt, ist durch die Bemessung der Gleichrichterschaltung GL, insbesondere der Zenerdiode ZD und des Ladekondensators $C_L$, bestimmt. Innerhalb der Zeit zwischen dem letzten, am Eingang 1 erschienenen Impuls und dem Verschwinden der Gleichspannung am Toreingang 9 ist die Schaltungsanordnung somit nicht gesetzt, d. h., wenn innerhalb dieser Zeit die Eingangsimpulsfolge wieder erscheint, so wird sie an den Ausgang 5 weitergegeben. Verschwindet dagegen nach der vorgegebenen Zeitspanne die Gleichspannung am Toreingang 9, dann werden keine Impulse mehr auf den Ausgang 5 der Schaltungsanordnung weitergegeben, auch wenn die Impulsfolge am Eingang 1 wieder erscheinen sollte.

Die Schaltungsanordnung ist so ausgelegt, daß alle denkbaren Bauelementeausfälle in Richtung auf Setzen des Speichers, d. h. in Richtung auf eine logische « 1 » am Ausgang, hinwirken (failsafe-Eigenschaft). Zum Rücksetzen der Schaltungsanordnung sind die Rücksetzeingänge 16 oder 17 oder 18 am statischen Rücksetzbaustein SR sowie 15 am dynamischen Rücksetzbaustein DR vorhanden, über die ein dynamisches Signal über das dynamische UND (DU) (einsynchronisiert durch TE über den zusätzlichen Eingang am dynamischen UND-Baustein DU) auf den Eingang der bistabilen Kippstufe FF geschaltet werden kann und damit ebenfalls während einer kurzen Zeit die Torschaltung T geöffnet ist. Die Verknüpfungsschaltung M am Ausgang der Schaltungsanordnung dient der Realisierung einer dynamischen ODER-Verknüpfung mit dem Takt TE, der — wie bereits oben beschrieben — gegenüber dem Takt TA verschoben ist.

2. Schaltungsanordnung nach Anspruch 1, dadurch gekennzeichnet, daß

- die Gleichrichterschaltung (GL) aus einer bistabilen Kippstufe (FF), einem Übertrager (Ü), einem Gleichrichter (G) und einem Glättungskondensator ($C_L$) besteht, wobei

- der Übertrager (Ü) zwei Primärwicklungen (N1', N1") aufweist, deren beide äußere Anschlüsse an die beiden Ausgänge der Kippstufe (FF) und deren Verbindungspunkt an die Versorgungsspannung ($U_P$) angeschlossen ist (Figur 2).

## Patentansprüche

1. Schaltungsanordnung zur Speicherung dynamischer logischer Signale, in der

— eine logische « 0 » durch eine Impulsfolge und eine logische « 1 » durch ein statisches Signal definiert sind, dadurch gekennzeichnet, daß

— am Eingang (1) der Schaltungsanordnung eine Torschaltung (T), die neben einem Signaleingang (2) und einem Signalausgang (3) einen Steuereingang (9) aufweist und die das an ihrem Signaleingang (2) liegende Signal zu ihrem Signalausgang (3) durchschaltet falls eine Gleichspannung an diesem Steuereingang anliegt, vorhanden ist, deren Ausgang (3) über ein als dynamisch logische ODER-Funktion realisiertes Verknüpfungselement (M) mit dem Ausgang (5) der Schaltungsanordnung verbunden ist,

— der Ausgang (3) der Torschaltung (T) weiterhin über einen dynamischen UND-Baustein (DU) mit einer Gleichrichterschaltung (GL) verbunden ist, die

— bei Anliegen einer Impulsfolge ein Gleichspannungssignal erzeugt, das auch bei Lücken in der Impulsfolge für einen von den Bemessungen der Bauelemente der Gleichrichterschaltung (GL) abhängigen Zeitraum aufrechterhalten wird,

— der Ausgang der Gleichrichterschaltung (GL) auf den Steuereingang (9) der Torschaltung (T) zur Aufrechterhaltung der dort anliegende Gleichspannung für den Zeitraum zurückgeführt ist und daß

— der dynamische UND-Baustein mit weiteren Signalen zum Rücksetzen der Torschaltung (T) beaufschlagbar ist.

3. Schaltungsanordnung nach Anspruch 1 oder 2, dadurch gekennzeichnet, daß

— parallel zum Glättungskondensator (C_L) eine Zenerdiode (ZD) geschaltet ist.

4. Schaltungsanordnung nach einem der Ansprüche 1 oder 2, dadurch gekennzeichnet, daß

— ein dynamischer Rücksetzbaustein (DR) mit einem Eingang (15) für ein statisches Freigabesignal und ein dynamisches Rücksetzsignal

— und ein statischer Rücksetzbaustein (SR) mit Eingängen (16, 17, 18) für statische Rücksetzsignale vorhanden ist und daß

— der statische Rücksetzbaustein (SR) mit einem ersten Taktsignal (TA) versorgt wird, dessen Taktfrequenz mit der des Eingangssignals der Schaltungsanordnung phasengleich ist.

5. Schaltungsanordnung nach Anspruch 4, dadurch gekennzeichnet, daß

— ein zusätzlicher Eingang des dynamischen UND-Bausteins (DU) mit einem ersten Taktsignal (TE) beaufschlagt ist, das zum zweiten Taktsignal (TA) derart phasenverschoben ist, daß die Impulse in der Mitte zwischen den Impulsen vom zweiten Taktsignal (TA) liegen, und das die Phasenlage der Impulsfolge am Ausgang des dynamischen UND-Bausteins (DU) bestimmt.

## Claims

1. Circuit arrangement for storing dynamic logic signals, in which

— a logical « 0 » is defined by a pulse train and a logical « 1 » is defined by a static signal, characterised in that

— at the input (1) of the circuit arrangement there is a gate circuit (T) which in addition to a signal input (2) and a signal output (3) has a control input (9) and which switches the signal applied to its signal input (2) through to its signal output (3) if a d. c. voltage is applied at this control input, and the output (3) of which is connected with the output (5) of the circuit arrangement by way of a connecting element (M) realized as a dynamic logic OR-function,

— the output (3) of the gate circuit (T) is connected, furthermore, by way of a dynamic AND-function block (DU) with a rectifier circuit (GL), which

— with application of a pulse train produces a d. c. voltage signal which even when there are gaps in the pulse train is maintained for a period of time dependent upon the dimensions of the components of the rectifier circuit (GL),

— the output of the rectifier circuit (GL) is led back to the control input (9) of the gate circuit (T) in order to maintain the d. c. voltage applied there for the period of time and in that

— the dynamic AND-function block can be acted on by further signals in order to reset the gate circuit (T).

2. Circuit arrangement according to claim 1, characterised in that

— the rectifier circuit (GL) consists of a bistable flip-flop (FF), a transformer (Ü), a rectifier (G) and a smoothing capacitor (C_L), in which case

— the transformer (Ü) has two primary windings (N1', N1''), the two outer connections of which are connected to the two outputs of the flip-flop (FF) and the connection point of which is connected to the supply voltage (U_p) (Figure 2).

3. Circuit arrangement according to claim 1 or 2, characterised in that

— a Zener diode (ZD) is connected in parallel to the smoothing capacitor (C_L).

4. Circuit arrangement according to one of the claims 1 or 2, characterised in that

— a dynamic reset block (DR) with an input (15) for a static release signal and a dynamic reset signal

— and a static reset block (SR) with inputs (16, 17, 18) for static reset signals are present and in that

— the static reset block (SR) is supplied with a first clock signal (TA), the clock frequency of which is in phase with that of the input signal of the circuit arrangement.

5. Circuit arrangement according to claim 4, characterised in that

— a first clock signal (TE) acts upon an additional input of the dynamic AND-function block (DU), said clock signal being phase-shifted in respect of the second clock signal (TA) such that the pulses lie in the middle between the pulses from the second clock signal (TA) and determining the phase position of the pulse train at the output of the dynamic AND-function block (DU).

## Revendications

1. Montage pour mémoriser des signaux logiques dynamiques, dans lequel

— un « 0 » logique est défini par une suite d'impulsions et un « 1 » logique est défini par un signal statique, caractérisé par le fait que

— il est prévu à l'entrée (1) du montage un circuit de porte (T), qui comporte une entrée de commande (9) en plus d'une entrée (2) des signaux et d'une sortie (3) des signaux et transmet directement le signal présent sur son entrée (2) des signaux à sa sortie (3) des signaux, dans le cas où une tension continue est appliquée à cette entrée de commande, et dont la sortie (3) est reliée à la sortie (5) du montage par l'intermédiaire d'un élément combinatoire (M) réalisé en tant que fonction OU logique dynamique,

— la sortie (3) du circuit de porte (T) est en outre reliée par l'intermédiaire d'un module ET dynamique (DU) à un circuit redresseur (GL1), qui

— produit, lors de l'application d'une suite d'impulsions, un signal de tension continue, qui est également maintenu lors de vides dans la suite d'impulsions, pendant un intervalle de temps dépendant des dimensions des composants du circuit redresseur (GL),

— la sortie du circuit redresseur (GL) est renvoyée, pendant ledit intervalle de temps, à l'entrée de commande (9) du circuit de porte (T) pour le maintien de la tension continue qui y est appliquée, et que

— le module ET dynamique peut être chargé par d'autres signaux pour la remise à l'état initial du circuit de porte (T).

2. Montage suivant la revendication 1, caractérisé par le fait que

— le circuit redresseur (GL) est formé par un étage à bascule bistable (FF), un transformateur (U), un redresseur (G) et un condensateur de lissage ($C_L$),

— le transformateur (Ü) étant constitué par deux enroulements primaires (N1', N1''), dont les deux bornes extérieures sont raccordées aux deux sorties de l'étage à bascule (FF) et dont le point de jonction est placé à la tension d'alimentation ($U_P$) (figure 2).

3. Montage suivant la revendication 1 ou 2, caractérisé par le fait que

— une diode Zener (ZD) est branchée en parallèle avec le condensateur de lissage ($C_L$).

4. Montage suivant l'une des revendications 1 ou 2, caractérisé par le fait qu'il est prévu

— un module dynamique de remise à l'état initial (DR) comportant une entrée (15) pour un signal statique de libération et un signal dynamique de remise à l'état initial, et

— un module statique de remise à l'état initial (SR) comportant des entrées (16, 17, 18) pour des signaux statiques de remise à l'état initial, et que

— le module statique de remise à l'état initial (SR) est alimenté par un premier signal de cadence (TA), dont la fréquence d'horloge est en phase avec celle du signal d'entrée du montage.

5. Montage suivant la revendication 4, caractérisé par le fait que

— une entrée supplémentaire du module ET dynamique (DU) est chargée par un premier signal de cadence (TE) qui est déphasé par rapport au second signal de cadence (TA) de telle sorte que les impulsions sont situées dans la zone médiane entre les impulsions du second signal de cadence (TA), et déterminent la position de phase de la suite d'impulsions à la sortie du module ET dynamique (DU).

FIG 1

1

FIG 2